# EUROPEAN PATENT APPLICATION

(11) **EP 4 472 107 A1**
(43) Date of publication of application: **04.12.2024**
(21) Application number: 23787619.8
(22) Date of filing: 08.04.2023
(51) Int. Cl.: H04B 10/61

(54) **OPTICAL RECEIVER**

(30) Priority: 15.04.2022 CN 202210399445
(71) Applicant: Huawei Technologies Co., Ltd., Shenzhen, Guangdong 518129 (CN)
(72) Inventor: CAO, Rixiang, Shenzhen, Guangdong 518129 (CN); YU, Yuquan, Shenzhen, Guangdong 518129 (CN); ZHANG, Zhenhua, Shenzhen, Guangdong 518129 (CN)
(74) Representative: Maiwald GmbH
(86) International application number: PCT/CN2023/087171
(87) International publication number: WO 2023/197975

(57) **Abstract**

This application relates to the field of optical communication technologies, and in particular, to an optical receiver, to provide a technical solution that can reduce electromagnetic crosstalk, so as to improve optical signal reception performance of the optical receiver, and ensure signal transmission accuracy. The optical receiver includes a photodetector and a trans-impedance amplifier that includes a first differential branch circuit, a second differential branch circuit, and a differential amplifier. The first differential branch circuit includes a first capacitor and a first trans-impedance amplifying unit, where an input end of the first capacitor receives an input signal from a power supply end of the photodetector, and an output end of the first capacitor is coupled to an input end of the first trans-impedance amplifying unit. The first differential branch circuit is configured to: amplify the input signal and output a reference signal. The second differential branch circuit is configured to amplify an electrical signal from the photodetector. Signal physical parameter values of the reference signal and an interference signal included in an amplified electrical signal are the same or similar.

## Description

This application claims priority to Chinese Patent Application No. 202210399445.6, filed with the China National Intellectual Property Administration on April 15, 2022 and entitled "OPTICAL RECEIVER", which is incorporated herein by reference in its entirety.

### TECHNICAL FIELD

This application relates to the field of optical communication technologies, and in particular, to an optical receiver.

### BACKGROUND

With the advantages of an ultra-high bandwidth and low electromagnetic crosstalk, optical communication networks are massively deployed. In optical communication networks, optical communication devices mainly achieve signal reception using an optical receiver.

However, due to the fact that optical communication devices are typically operate in complex electromagnetic radiation environments, electromagnetic crosstalk may occur in a process in which the optical receiver processes optical signals. How to reduce electromagnetic crosstalk signals present in the optical receiver is a topic worthy of research.

### SUMMARY

Embodiments of this application provide an optical receiver, to provide a technical solution that can reduce electromagnetic crosstalk of the optical receiver, so as to improve performance of receiving an optical signal by the optical receiver, and ensure signal transmission accuracy.

According to a first aspect, an optical receiver is provided. The optical receiver includes a photodetector and a trans-impedance amplifier, where the trans-impedance amplifier includes a first differential branch circuit, a second differential branch circuit, and a differential amplifier. The first differential branch circuit includes a first capacitor and a first trans-impedance amplifying unit, where an input end of the first capacitor receives an input signal from a power supply end of the photodetector, an output end of the first capacitor is coupled to an input end of the first trans-impedance amplifying unit, and an output end of the first trans-impedance amplifying unit is coupled to a first input end of the differential amplifier. The second differential branch circuit includes a second trans-impedance amplifying unit, an input end of the second trans-impedance amplifying unit is coupled to an output end of the photodetector, and an output end of the second trans-impedance amplifying unit is coupled to a second input end of the differential amplifier. The first differential branch circuit is configured to: amplify the input signal and output a reference signal; the second differential branch circuit is configured to amplify an electrical signal output by the photodetector, where signal physical parameter values of the reference signal and an interference signal included in an amplified electrical signal are the same; or a signal physical parameter value difference between the reference signal and an interference signal included in an amplified electrical signal is less than a first difference; and the differential amplifier is configured to perform differential amplification processing on the reference signal and the amplified electrical signal.

In the optical receiver provided in this application, to eliminate interference signals caused by electromagnetic crosstalk, the optical receiver provided in this embodiment of this application divides the possible interference signals into two parts, and separately transmits the two parts of interference signals to the differential amplifier, so that the two parts of differential-mode interference signals can be canceled at the differential amplifier. Therefore, reception performance of the optical receiver can be improved, and a signal-to-noise ratio of a transmitted signal can be increased.

In a possible design, the trans-impedance amplifier further includes a first voltage regulator, where an output end of the first voltage regulator is coupled between an input end of the photodetector and the first capacitor; or the optical receiver further includes a second voltage regulator, where an output end of the second voltage regulator is coupled to an input end of the photodetector. The first voltage regulator or the second voltage regulator is configured to provide a bias voltage for the photodetector.

In this design, an interference signal caused by electromagnetic crosstalk and other factors may come from outside of the trans-impedance amplifier, or may come from inside of the trans-impedance amplifier. Regardless of whether a voltage regulator that provides a bias voltage for the photodetector is placed inside or outside of the trans-impedance amplifier, the interference signal may be divided into two parts based on the design idea provided in this application, and the two parts of signals are separately input into the differential amplifier.

In a possible design, the trans-impedance amplifier further includes a second capacitor, where an input end of the second capacitor is coupled between the input end of the photodetector and the first capacitor, and an output end of the second capacitor is coupled to a reference plane; or the optical receiver further includes a third capacitor, where an input end of the third capacitor is coupled between the first voltage regulator and the photodetector, or coupled between the second voltage regulator and the photodetector, and an output end of the third capacitor is coupled to a reference plane. The second capacitor or the third capacitor is configured to filter out some interference from the first voltage regulator or the second voltage regulator, where a capacitance value of the second capacitor or the third capacitor is greater than a preset capacitance threshold. The reference plane may be, for example, a ground cable; or a power supply end different from that of the first voltage regulator or the second voltage regulator.

In this design, to improve efficiency for eliminating interference signals by the optical receiver, a capacitor connected to the reference plane is coupled before the input end of the photodetector, so that some interference signals can be filtered out by the capacitor, to reduce interference signals included in a signal transmission process, reduce impact of an interference signal on optical signal reception, and ensures performance of optical signal reception of the optical receiver.

In a possible design, the optical receiver further includes a common-mode filter, where an input end of the common-mode filter is coupled to an output end of the differential amplifier. The common-mode filter is configured to filter out common-mode interference signals included in an electrical signal obtained through differential amplification processing.

In this design, in addition to cancellation of a differential-mode part of the interference signals in the differential amplifier, to avoid interference caused by a common-mode part of the interference signals to a subsequent signal transmission process, the common-mode part of the interference signals may be further eliminated by the common-mode filter at a location behind the differential amplifier. Therefore, the reception performance of the optical receiver can be improved, and the signal-to-noise ratio of the transmitted signal can be increased.

In a possible design, the common-mode filter is disposed in a chip of the trans-impedance amplifier, disposed on a transmission link between the trans-impedance amplifier and a next-stage unit, or disposed in an input stage of the next-stage unit, where the next-stage unit is a buffer or an amplifier.

In a possible design, that signal physical parameter values of the reference signal and an interference signal included in an amplified electrical signal are the same; or a signal physical parameter value difference between the reference signal and an interference signal included in an amplified electrical signal is less than a first difference specifically includes: Values of the first capacitor and parasitic capacitance of the photodetector are the same; or a difference between values of the first capacitor and parasitic capacitance of the photodetector is less than a second difference; and amplification multiples of the first trans-impedance amplifying unit and the second trans-impedance amplifying unit are equal; or a difference between amplification multiples of the first trans-impedance amplifying unit and the second trans-impedance amplifying unit is less than a third difference.

In this design, the first capacitor and the parasitic capacitance of the photodetector are set to be the same as or similar, and the amplification multiple of the first trans-impedance amplifying unit and the amplification multiple of the second trans-impedance amplifying unit are set to be the same as or similar, so that the two parts of interference signals input into the differential amplifier may be the same or similar. Therefore, the two parts of interference signals can be canceled at the differential amplifier, to improve the reception performance of the optical receiver and increase the signal-to-noise ratio of the transmitted signal.

In another possible design, that signal physical parameter values of the reference signal and an interference signal included in an amplified electrical signal are the same; or a signal physical parameter value difference between the reference signal and an interference signal included in an amplified electrical signal is less than a first difference includes one or a combination of the following manners: adjusting an amplification multiple of the first trans-impedance amplifying unit; and adjusting an amplification multiple of the second trans-impedance amplifying unit.

In this design, the amplification multiple of the first trans-impedance amplifying unit and/or the amplification multiple of the second trans-impedance amplifying unit can be adaptively adjusted, to allow the signal physical parameter values of the interference signals included in the reference signal and the amplified electrical signal be the same or similar. Therefore, the two parts of interference signals can further be canceled at the differential amplifier, to improve the reception performance of the optical receiver and increase the signal-to-noise ratio of the transmitted signal.

In a possible design, the trans-impedance amplifier further includes a gain control unit, where an input end of the gain control unit is coupled to an input end or the output end of the differential amplifier; and the output end is coupled to the input end of the first trans-impedance amplifying unit, coupled to the input end of the second trans-impedance amplifying unit, or separately coupled to the input end of the first trans-impedance amplifying unit and the input end of the second trans-impedance amplifying unit. The gain control unit is configured to obtain a first signal physical parameter value of the reference signal and a second signal physical parameter value of the interference signal included in the amplified electrical signal; and the gain control unit is further configured to: based on a difference between the first signal physical parameter value and the second signal physical parameter value, adjust the amplification multiple of the first trans-impedance amplifying unit, adjust the amplification multiple of the second trans-impedance amplifying unit, or separately adjust the amplification multiple of the first trans-impedance amplifying unit and the amplification multiple of the second trans-impedance amplifying unit.

In this design, the gain control unit is disposed in the trans-impedance amplifier, so that the trans-impedance amplifier can automatically perform adaptive adjustment based on the relationship between the signal physical parameter values of the interference signals in two differential branch circuits, to allow the signal physical parameter values of the interference signals included in the reference signal and the amplified electrical signal be the same or similar. Therefore, the two parts of interference signals can further be canceled at the differential amplifier, to further improve the reception performance of the optical receiver and increase the signal-to-noise ratio of the transmitted signal.

In a possible design, that the gain control unit is configured to: based on a difference between the first signal physical parameter value and the second signal physical parameter value, adjust the amplification multiple of the first trans-impedance amplifying unit, adjust the amplification multiple of the second trans-impedance amplifying unit, or separately adjust the amplification multiple of the first trans-impedance amplifying unit and the amplification multiple of the second trans-impedance amplifying unit is specifically configured to: increase or decrease the amplification multiple of the first trans-impedance amplifying unit, to allow the difference between the first signal physical parameter value and the second signal physical parameter value be less than a fourth difference; increase or decrease the amplification multiple of the second trans-impedance amplifying unit, to allow the difference between the first signal physical parameter value and the second signal physical parameter value be less than a fifth difference; or increase or decrease the respective amplification multiples of the first trans-impedance amplifying unit and the second trans-impedance amplifying unit, to allow the difference between the first signal physical parameter value and the second signal physical parameter value be less than a sixth difference.

In a possible design, the first signal physical parameter value or the second signal physical parameter value is obtained in at least one of the following manners: signal peak detection, signal root mean square value detection, and signal direct current level detection. In this design, during specific implementation, an appropriate signal physical parameter value can be selected based on an actual scenario to perform gain control, so that an interference signal elimination effect of the optical receiver can be ensured, and the reception performance of the optical receiver can be ensured.

In a possible design, the trans-impedance amplifier further includes a power-on detection unit and a power supply module, where an input end of the power-on detection unit is coupled to an output end of the power supply module, and an output end is coupled to the gain control unit. The power-on detection unit is configured to detect a power-on signal of the trans-impedance amplifier; and the power-on detection unit is further configured to control, within preset duration starting from a time point at which the power-on signal is detected, the gain control unit to work.

In a possible design, the optical receiver further includes a control circuit, and the control circuit is separately connected to the photodetector and the power supply module of the trans-impedance amplifier. The control circuit is configured to: before the photodetector works or receives an optical signal, control the power supply module of the trans-impedance amplifier to be powered on.

In this design, the amplification multiple of the first trans-impedance amplifying unit and/or the amplification multiple of the second trans-impedance amplifying unit can be adjusted using the control circuit before the optical receiver works normally, to allow the signal physical parameter values of the interference signals included in the reference signal and the amplified electrical signal be the same or similar. Therefore, the two parts of interference signals can further be cancelled at the differential amplifier, to improve the reception performance of the optical receiver and increase the signal-to-noise ratio of the transmitted signal. In this way, the interference signals for the optical receiver can be canceled, and impact on a reception process of a normal optical signal can further be avoided.

According to a second aspect, another optical receiver is further provided. The optical receiver includes a photodetector and a trans-impedance amplifier. The trans-impedance amplifier includes a first differential branch circuit, a second differential branch circuit, and a common-mode filter. The first differential branch circuit includes a first capacitor and a first trans-impedance amplifying unit, where an input end of the first capacitor receives an input signal from a power supply end of the photodetector, an output end of the first capacitor is coupled to an input end of the first trans-impedance amplifying unit, and an output end of the first trans-impedance amplifying unit is coupled to a first input end of the common-mode filter. The second differential branch circuit includes a second trans-impedance amplifying unit, where an input end of the second trans-impedance amplifying unit is coupled to an output end of the photodetector, and an output end of the second trans-impedance amplifying unit is coupled to a second input end of the common-mode filter. The first differential branch circuit is configured to: amplify the input signal and output a reference signal, and the second differential branch circuit is configured to amplify an electrical signal output by the photodetector. Signal physical parameter values of the reference signal and an interference signal included in an amplified electrical signal are the same; or a signal physical parameter value difference between the reference signal and an interference signal included in an amplified electrical signal is less than a first difference. The common-mode filter is configured to perform filtering processing on the reference signal and the amplified electrical signal.

In the optical receiver, to eliminate possible electromagnetic crosstalk signals, the optical receiver provided in this embodiment of this application divides the possible interference signals into two parts and separately transmits the two parts of interference signals to the common-mode filter, so that the two parts of common-mode interference signals can be canceled at the common-mode filter. Therefore, reception performance of the optical receiver can be improved, and a signal-to-noise ratio of a transmitted signal can be increased.

In a possible design, the common-mode filter is disposed in a chip of the trans-impedance amplifier, disposed on a transmission link between the trans-impedance amplifier and a next-stage unit, or disposed in an input stage of the next-stage unit, where the next-stage unit is a buffer or an amplifier.

In a possible design, the trans-impedance amplifier further includes a first voltage regulator, where an output end of the first voltage regulator is coupled between an input end of the photodetector and the first capacitor; or the optical receiver further includes a second voltage regulator, where an output end of the second voltage regulator is coupled to an input end of the photodetector. The first voltage regulator or the second voltage regulator is configured to provide a bias voltage for the photodetector.

In a possible design, the trans-impedance amplifier further includes a second capacitor, where an input end of the second capacitor is coupled between the input end of the photodetector and the first capacitor, and an output end of the second capacitor is coupled to a reference plane; or the optical receiver further includes a third capacitor, where an input end of the third capacitor is coupled between the first voltage regulator and the photodetector, or coupled between the second voltage regulator and the photodetector, and an output end of the third capacitor is coupled to a reference plane. The second capacitor or the third capacitor is configured to filter out some interference from the first voltage regulator or the second voltage regulator, where a capacitance value of the second capacitor or the third capacitor is greater than a preset capacitance threshold. The reference plane may be, for example, a ground cable; or a power supply end different from that of the first voltage regulator or the second voltage regulator.

In a possible design, that signal physical parameter values of the reference signal and an interference signal included in an amplified electrical signal are the same; or a signal physical parameter value difference between the reference signal and an interference signal included in an amplified electrical signal is less than a first difference specifically includes: Values of the first capacitor and parasitic capacitance of the photodetector are the same; or a difference between values of the first capacitor and parasitic capacitance of the photodetector is less than a second difference; and amplification multiples of the first trans-impedance amplifying unit and the second trans-impedance amplifying unit are equal; or a difference between amplification multiples of the first trans-impedance amplifying unit and the second trans-impedance amplifying unit is less than a third difference.

In another possible design, that signal physical parameter values of the reference signal and an interference signal included in an amplified electrical signal are the same; or a signal physical parameter value difference between the reference signal and an interference signal included in an amplified electrical signal is less than a first difference includes one or a combination of the following manners: adjusting an amplification multiple of the first trans-impedance amplifying unit; and adjusting an amplification multiple of the second trans-impedance amplifying unit.

In a possible design, the trans-impedance amplifier further includes a gain control unit, where an input end of the gain control unit is coupled to an input end or the output end of the common-mode filter; and the output end is coupled to the input end of the first trans-impedance amplifying unit, coupled to the input end of the second trans-impedance amplifying unit, or separately coupled to the input end of the first trans-impedance amplifying unit and the input end of the second trans-impedance amplifying unit. The gain control unit is configured to obtain a first signal physical parameter value of the reference signal and a second signal physical parameter value of the interference signal included in the amplified electrical signal; and the gain control unit is further configured to: based on a difference between the first signal physical parameter value and the second signal physical parameter value, adjust the amplification multiple of the first trans-impedance amplifying unit, adjust the amplification multiple of the second trans-impedance amplifying unit, or separately adjust the amplification multiple of the first trans-impedance amplifying unit and the amplification multiple of the second trans-impedance amplifying unit.

In a possible design, that the gain control unit is configured to: based on a difference between the first signal physical parameter value and the second signal physical parameter value, adjust the amplification multiple of the first trans-impedance amplifying unit, adjust the amplification multiple of the second trans-impedance amplifying unit, or separately adjust the amplification multiple of the first trans-impedance amplifying unit and the amplification multiple of the second trans-impedance amplifying unit is specifically configured to: increase or decrease the amplification multiple of the first trans-impedance amplifying unit, to allow the difference between the first signal physical parameter value and the second signal physical parameter value be less than a fourth difference; increase or decrease the amplification multiple of the second trans-impedance amplifying unit, to allow the difference between the first signal physical parameter value and the second signal physical parameter value be less than a fifth difference; or increase or decrease the respective amplification multiples of the first trans-impedance amplifying unit and the second trans-impedance amplifying unit, to allow the difference between the first signal physical parameter value and the second signal physical parameter value be less than a sixth difference.

In a possible design, the first signal physical parameter value or the second signal physical parameter value is obtained in at least one of the following manners: signal peak detection, signal root mean square value detection, and signal direct current level detection.

In a possible design, the trans-impedance amplifier further includes a power-on detection unit and a power supply module, where an input end of the power-on detection unit is coupled to an output end of the power supply module, and an output end is coupled to the gain control unit. The power-on detection unit is configured to detect a power-on signal of the trans-impedance amplifier; and the power-on detection unit is further configured to control, within preset duration starting from a time point at which the power-on signal is detected, the gain control unit to work.

In a possible design, the optical receiver further includes a control circuit, and the control circuit is separately connected to the photodetector and the power supply module of the trans-impedance amplifier. The control circuit is configured to: before the photodetector works or receives an optical signal, control the power supply module of the trans-impedance amplifier to be powered on.

According to a third aspect, an embodiment of this application further provides an optical communication device, including the optical receiver described in any one of the first aspect or any one of the possible designs of the first aspect, or the optical receiver described in any one of the second aspect or any one of the possible designs of the second aspect, and one or more processors. The one or more processors are configured to receive and process a data packet transmitted by the optical receiver.

For beneficial effects of any possible design included in the second aspect, refer to the optical receiver in the designs in the first aspect. In addition, because the optical communication device in the third aspect includes the optical receiver in the designs of the first aspect, the optical communication device also has the technical effects achievable by the designs of the first aspect. Details are not described herein again.

### BRIEF DESCRIPTION OF DRAWINGS

FIG. 1 is a diagram of a scenario of an optical communication system;
FIG. 2 is an example diagram of an optical receiver;
FIG. 3 is a first diagram of an optical receiver 300 according to an embodiment of this application;
FIG. 4 is a second diagram of an optical receiver 300 according to an embodiment of this application;
FIG. 5 is a third diagram of an optical receiver 300 according to an embodiment of this application;
FIG. 6 is a fourth diagram of an optical receiver 300 according to an embodiment of this application;
FIG. 7 is a fifth diagram of an optical receiver 300 according to an embodiment of this application;
FIG. 8 is a sixth diagram of an optical receiver 300 according to an embodiment of this application;
FIG. 9a is a seventh diagram of an optical receiver 300 according to an embodiment of this application;
FIG. 9b is an eighth diagram of an optical receiver 300 according to an embodiment of this application;
FIG. 10 is a ninth diagram of an optical receiver 300 according to an embodiment of this application;
FIG. 11 is an example diagram of a common-mode filter 307 according to an embodiment of this application;
FIG. 12a is a signal diagram of an optical receiver 300 according to an embodiment of this application;
FIG. 12b is another signal diagram of an optical receiver 300 according to an embodiment of this application;
FIG. 12c is still another signal diagram of an optical receiver 300 according to an embodiment of this application; and
FIG. 13 is a diagram of an optical receiver 400 according to an embodiment of this application.

### DESCRIPTION OF EMBODIMENTS

The following describes technical solutions in embodiments of this application in detail with reference to the accompanying drawings in embodiments of this application.

An optical receiver provided in embodiments of this application may be used in an optical communication system, and the optical communication system may be, for example, a PON system. The PON system is a point 2 multipoint (point 2 multiple point, P2MP)-based communication technology. For example, the PON system may be an ethernet passive optical network (ethernet PON, EPON) system, a gigabit-capable passive optical network (gigabit-capable PON, GPON) system, a wavelength division multiplexing passive optical network (wavelength division multiplexing PON, WDM PON) system, or an asynchronous transfer mode passive optical network (asynchronous transfer mode PON, APON) system.

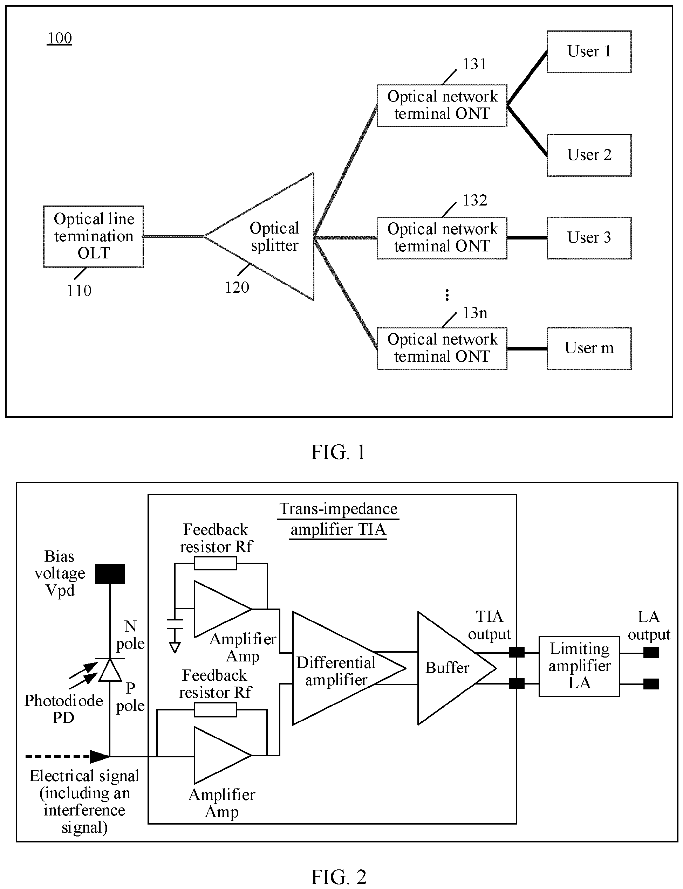

In a possible example application scenario, FIG. 1 is a diagram of some scenarios of an optical communication system. The PON system 100 may include at least one or more optical network terminals (optical network terminals, ONTs) or optical network units (optical network units, ONUs), and an optical splitter 120. For ease of description, the ONT refers to the ONT or the ONU in this document. If there are a plurality of ONTs, the plurality of ONTs may communicate with an upper-layer access device through the optical splitter 120. The upper-layer access device may be, for example, an optical line termination (optical line termination, OLT) 110. For example, in FIG. 1, the plurality of ONTs included in the PON system 100 may be an ONT 131, an ONT 132, ..., and an ONT 13n. Each ONT may be connected to a plurality of users. For example, the ONT 131 may be connected to a user 1 and a user 2. Alternatively, the ONT may be connected to one user. For example, the ONT 132 may be connected to a user 3, and the ONT 13n may be connected to a user m. In this way, the OLT 110 may provide a network side interface for the PON system 100. The ONT may be used as a terminal device on a user side in the optical communication system, may provide a service interface for a user, and has an electrical-optical conversion function, to implement a signal conversion process between the user and an access network.

With reference to the content described in the background, because ONTs may have complex electromagnetic radiation in many environments, electromagnetic crosstalk may exist when an optical receiver included in the ONT receives an optical signal. For example, in a 10 gigabit per second passive optical network (10 gigabit per second passive optical network, 10G PON), 5 GHz (Hz) is a commonly used signal modulation frequency, which has a same frequency band as 5G frequency band wireless-fidelity (wireless-fidelity, Wi-Fi) carriers. Therefore, it is difficult to perform filtering by using a conventional filtering method (for example, using a filter). For another example, even if interference signals have different modulation frequencies from optical signals, it may also be difficult to achieve a good filtering effect by using a conventional filtering method due to complexity of interference signals (for example, a plurality of interference signals may have different frequencies).

In view of this, embodiments of this application provide an optical receiver. Interference signals that may exist are input into a differential amplifier through two differential branch circuits, and amplitudes of the two parts of interference signals are adjusted to be the same or similar, so that the interference signals can be further filtered out through the differential amplifier. Alternatively, common-mode interference signals that may exist may be input into a common-mode filter through two differential branch circuits, and amplitudes of the two parts of common-mode interference signals are adjusted to be the same or similar, so that the common-mode interference signals can be further filtered out through the common-mode filter. Therefore, the technical solutions provided in embodiments of this application can reduce electromagnetic crosstalk in the optical receiver, to improve optical signal reception performance of the optical receiver, and ensure signal transmission accuracy.

FIG. 2 is an example diagram of an optical receiver. The optical receiver may be configured to receive, for an ONT in an optical communication system, an optical signal, and convert the optical signal into an electrical signal, to implement signal transmission. Generally, the optical receiver may include at least a photodetector and a trans-impedance amplifier.
(1) The photodetector is configured to: receive an optical signal, and convert the optical signal into an electrical signal. For example, the photodetector may be a photodiode (photodiode, PD) in FIG. 2. After a bias voltage (for example, denoted by Vpd) is provided for the PD, if the provided bias voltage is greater than or equal to a threshold voltage (for example, denoted by Vth) for normal working of the PD, that is, Vpd>_Vth, the PD may work normally. Vpd may be provided to the PD via an N pole of the PD, to drive the PD to work normally, and an electrical signal generated through processing by the PD may be output via a P pole of the PD, for example, transmitted to the trans-impedance amplifier.
(2) The trans-impedance amplifier (trans-impedance amplifier, TIA) is mainly configured to amplify a current signal from the photodetector. In the TIA, after being amplified by a pre-trans-impedance amplifying unit, an amplified electrical signal may be used as an input of a differential amplifier. The pre-trans-impedance amplifying unit may usually include a feedback resistor and an amplifier (amplifier, Amp) that are connected in parallel. To implement input of the differential amplifier, another dummy amplifier (dummy TIA) may be further provided in the TIA, and is mainly configured to provide a common-mode signal for the differential amplifier, to complete single-ended to differential conversion processing of a signal input into the differential amplifier. An electrical signal output by the photodetector is usually a current signal, and the current signal may be converted into a voltage signal after passing through the TIA. In embodiments of this application, the current signal and the voltage signal are collectively referred to as an "electrical signal".

For another example, if the TIA does not include a differential amplifier, after an electrical signal is amplified by the pre-trans-impedance amplifying unit, an amplified electrical signal may alternatively be directly output by the TIA or transmitted to a next-stage unit (which may be, for example, a buffer or another amplifier) in the TIA. In other words, the electrical signal in the TIA may alternatively be transmitted in a single-ended manner. It may be understood that the TIA may further include a multi-stage buffer or another multi-stage amplifier.

In addition, the optical receiver may further include a limiting amplifier (limiting amplifier, LA). An electrical signal amplified by the trans-impedance amplifier may be further processed by the LA and then continues to be transmitted.

Based on the example shown in FIG. 2, it can be learned that an interference signal is transmitted to the TIA together with an electrical signal, and then the TIA amplifies the interference signal and the electrical signal together. As a result, reception performance of the optical receiver is affected, and a signal-to-noise ratio of a transmitted signal is reduced.

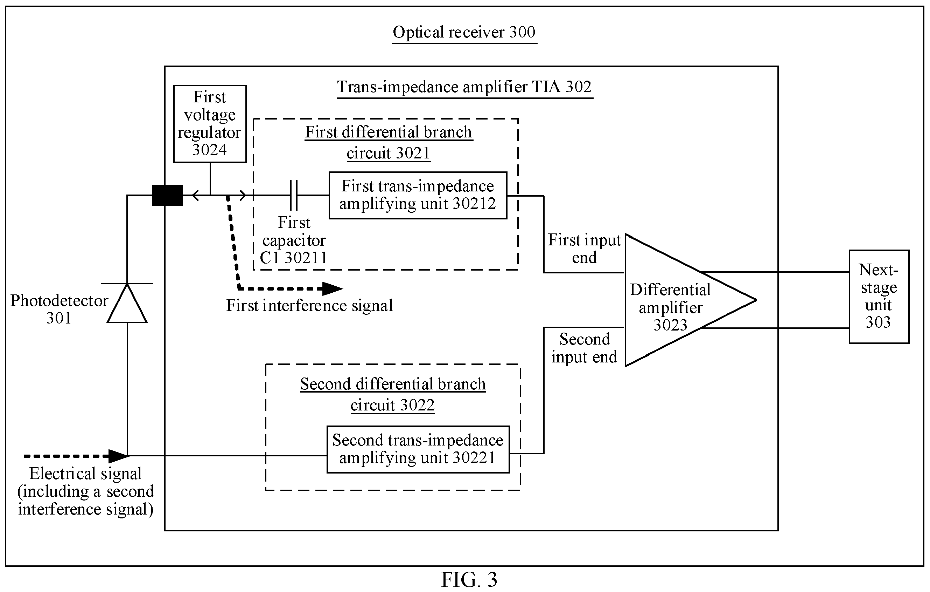

To reduce electromagnetic crosstalk in an optical receiver, embodiments of this application provide an optical receiver. FIG. 3 is a diagram of an optical receiver 300 according to an embodiment of this application. To eliminate possible electromagnetic crosstalk signals, the optical receiver provided in this embodiment of this application divides the possible interference signals into two parts, and separately transmits the two parts of interference signals to a differential amplifier, so that the two parts of interference signals can be canceled at the differential amplifier. Therefore, reception performance of the optical receiver 300 can be improved, and a signal-to-noise ratio of a transmitted signal can be increased. The optical receiver 300 provided in this embodiment of this application may include a photodetector 301 and a trans-impedance amplifier 302.

The photodetector 301 is configured to: receive an optical signal, and convert the optical signal into an electrical signal. For example, the photodetector may be a PD or another photoelectric conversion unit. This is not limited in this application.

In an optional example, usually, the photodetector 301 can work normally only when being driven by a bias voltage. During implementation of this application, a bias voltage may be provided by a first voltage regulator 3024 for the photodetector 301. The first voltage regulator 3024 may be integrated inside a trans-impedance amplifier 302, and an output end is coupled to an input end of the photodetector 301. For example, the first voltage regulator 3024 may be a low dropout regulator (low dropout regulator, LDO). In this way, the LDO may output a Vpd signal to the photodetector 301.

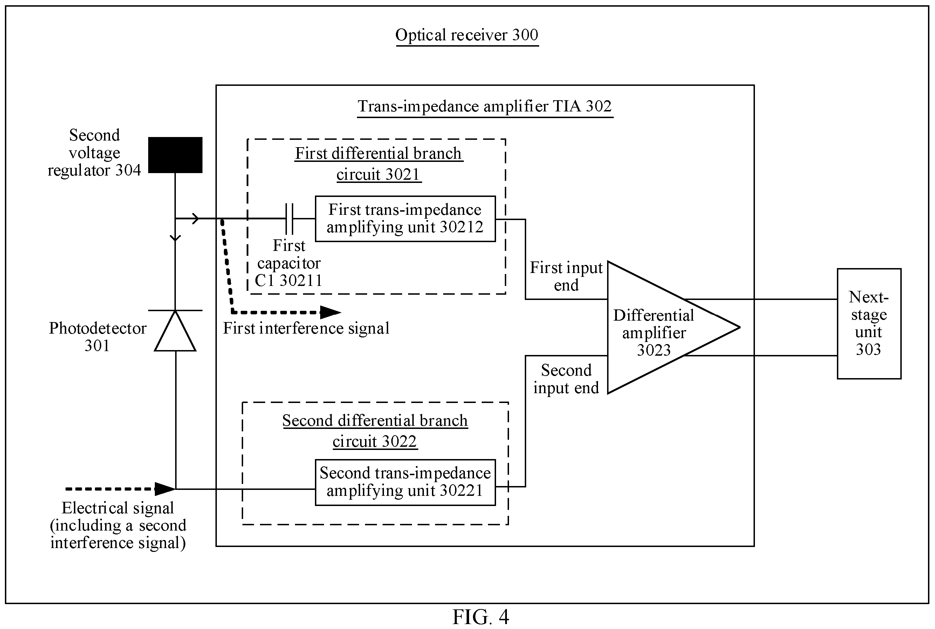

In another optional example, FIG. 4 is a diagram of another optical receiver 300 according to an embodiment of this application. During implementation of this application, a bias voltage may alternatively be provided by a second voltage regulator 304 for the photodetector 301. A difference between the second voltage regulator 304 and the first voltage regulator 3024 lies in that the second voltage regulator 304 may be integrated into the optical receiver 300 and is independent of the TIA 302. Similarly, an output end of the second voltage regulator 304 may be coupled to the input end of the photodetector 301.

For example, the photodetector 301 is a PD, and the PD generally has two ports: a P pole and an N pole. The PD may receive, via the N pole, a Vpd signal provided by the first voltage regulator 3024, or may receive a Vpd signal provided by the second voltage regulator 304. The PD may receive incident of an optical signal, and perform optical-electrical conversion on the optical signal. Then, the PD may continue to transmit, via the P pole, an electrical signal obtained through the optical-electrical conversion.

The trans-impedance amplifier (trans-impedance amplifier, TIA) 302 may include at least a first differential branch circuit 3021, a second differential branch circuit 3022, and a differential amplifier 3023. To eliminate an interference signal in an electrical signal, the first differential branch circuit 3021 in this embodiment of this application may include at least a first capacitor (C1) 30211 and a first trans-impedance amplifying unit 30212. An input end of the first capacitor (C1) 30211 may receive an input signal from a power supply end of the photodetector 301, and an output end of the first capacitor (C1) 30211 may be coupled to an input end of the first trans-impedance amplifying unit 30212. Optionally, the power supply end of the photodetector 301 may be the first voltage regulator 3024 shown in FIG. 3, or may be the second voltage regulator 304 shown in FIG. 4. This is not limited in this application.

In this way, a signal from the power supply end of the photodetector 301 may be divided into two parts of signals, one part of signal is transmitted to the first differential branch circuit 3021, and the other part of signal is transmitted to the second differential branch circuit 3022. For example, if a signal from the power supply end of the photodetector 301 includes an interference signal, the interference signal is also divided into two parts of interference signals (a first interference signal and a second interference signal shown in FIG. 3 and FIG. 4), the first interference signal is transmitted to the first differential branch circuit 3021, after passing through the photodetector 301, the second interference signal is transmitted to the second differential branch circuit 3022 together with an electrical signal. The second differential branch circuit 3022 may include at least a second trans-impedance amplifying unit 30221.

An output end of the first trans-impedance amplifying unit 30212 may be coupled to a first input end of the differential amplifier 3023, and an output end of the second trans-impedance amplifying unit 30221 is coupled to a second input end of the differential amplifier 3023. The first trans-impedance amplifying unit 30212 is used as an example. The output end of the first trans-impedance amplifying unit 30212 may be directly coupled to the input ends of the differential amplifier 3023, or may be indirectly coupled to the input ends of the differential amplifier 3023 through one or more elements such as capacitive coupling or inductive coupling. This is not limited in this application. A coupling manner of the second trans-impedance amplifying unit 30221 and the differential amplifier 3023 is similar to that of the first trans-impedance amplifying unit 30212 and the differential amplifier 3023. A coupling manner of the second trans-impedance amplifying unit 30221 and the differential amplifier 3023 different from that of the first trans-impedance amplifying unit 30212 and the differential amplifier 3023 may be used in the optical receiver 300. Details are not described herein.

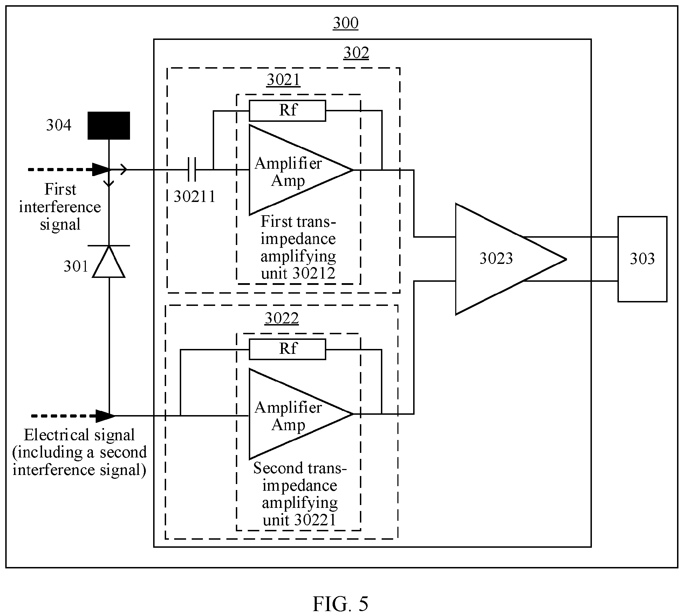

For example, FIG. 5 is a diagram of still another optical receiver 300 according to an embodiment of this application. An example in which FIG. 5 is based on the optical receiver shown in FIG. 4 is used for description. It should be noted that FIG. 5 may alternatively be based on the optical receiver shown in FIG. 3. The first trans-impedance amplifying unit 30212 and the second trans-impedance amplifying unit 30221 each may include a feedback resistor Rf and an amplifier (amplifier, Amp) that are connected in parallel. Gains of the first trans-impedance amplifying unit 30212 and the second trans-impedance amplifying unit 30221 may be the same or may be different. The first trans-impedance amplifying unit 30212 and the second trans-impedance amplifying unit 30221 can amplify input signals. For example, the second trans-impedance amplifying unit 30221 may further convert a current signal output by the photodetector 301 into a voltage signal. Based on this, a first interference signal may be amplified after passing through the first trans-impedance amplifying unit 30212, and an amplified first interference signal (which may also be referred to as a "reference signal" in this embodiment of this application) is output. An electrical signal (including a second interference signal) may also be amplified after passing through the second trans-impedance amplifying unit 30221, and an amplified electrical signal (including an amplified second interference signal) is output.

It may be understood that, if signal physical parameter values of the reference signal (the amplified first interference signal) from the first differential branch circuit 3021 and the second interference signal included in the amplified electrical signal from the second differential branch circuit 3022 are the same or similar (which may be implemented as that a signal physical parameter value difference is less than a first difference), differential mode cancellation between the amplified first interference signal and the amplified second interference signal can be implemented at the differential amplifier 3023. The first difference may be preset or a preset value obtained based on an experimental value. It may be understood that a smaller first difference indicates better reception performance of the optical receiver. In addition, the signal physical parameter value represents a value that can reflect a possible type of a signal feature, for example, a signal peak or a signal valid value. This is not limited in this application.

In an optional embodiment, if a value of parasitic capacitance of the photodetector 301 can be measured in advance, values of the first capacitor and the parasitic capacitance of the photodetector 301 may be set to be the same or similar (which may be implemented as that a difference is less than a second difference). In addition, in a scenario in which the first differential branch circuit 3021 and the second differential branch circuit 3022 do not include any other elements, gains (which may be denoted by amplification multiples) of the first trans-impedance amplifying unit and the second trans-impedance amplifying unit may be set to be equal or similar (which may be implemented as that a difference between the amplification multiples is less than a third difference). In this way, in the optical receiver 300, through such setting, the signal physical parameter values of the interference signals that are input into the differential amplifier 3023 and that are respectively from the two different differential branch circuits can be the same or similar, so that differential mode cancellation of the interference signals can be implemented, to reduce electromagnetic crosstalk of the optical receiver 300, and improve reception performance of the optical receiver 300. The second difference and the third difference may be preset or preset values obtained based on experimental values. It may be understood that a smaller difference between the signal physical parameter values of the interference signals respectively from the two different differential branch circuits indicates better reception performance of the optical receiver 300.

In another optional embodiment, if a value relationship between the first capacitor and parasitic capacitance of the photodetector 301 is not limited, or in a scenario in which the first differential branch circuit 3021 and the second differential branch circuit 3022 further include another element, alternatively, the signal physical parameter values of the interference signals that are input into the differential amplifier 3023 and that are respectively from the two differential branch circuits are the same or similar by adaptively adjusting an amplification multiple of the first trans-impedance amplifying unit, adaptively adjusting an amplification multiple of the second trans-impedance amplifying unit, or jointly adjusting amplification multiples of the first trans-impedance amplifying unit and the second trans-impedance amplifying unit.

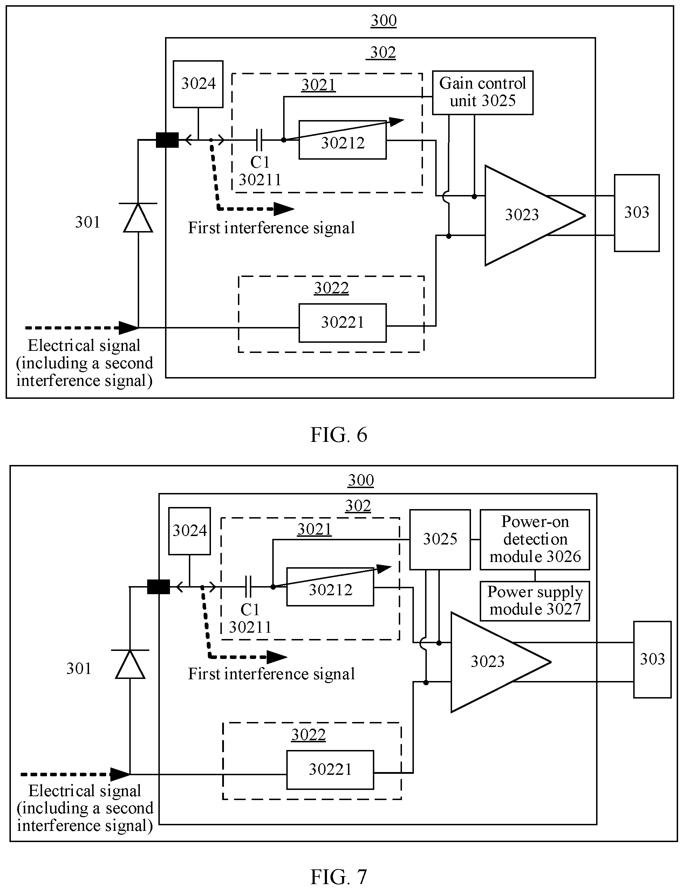

For example, FIG. 6 is a diagram of another optical receiver 300 according to an embodiment of this application. To adjust an amplification multiple of the first trans-impedance amplifying unit 30212 and/or an amplification multiple of the second trans-impedance amplifying unit 30221, during implementation of this application, the TIA 302 may further include a gain control unit 3025.

An input end of the gain control unit 3025 may be coupled to the input end or an output end of the differential amplifier 3023. In other words, the input end of the gain control unit 3025 may be coupled to any location between the first trans-impedance amplifying unit 30212 and a next-stage unit 303, for example, in a chip of the TIA 302, on a transmission link (which may also be referred to as a "signal path" or the like) between the first trans-impedance amplifying unit 30212 and the next-stage unit 303, or in an input stage of the next-stage unit 303. Optionally, the next-stage unit 303 may be, for example, an LA. For example, in FIG. 6, the input end of the gain control unit 3025 is coupled to the input end of the differential amplifier 3023.

An output end of the gain control unit 3025 may be coupled to the input end of the first trans-impedance amplifying unit 30212, may be coupled to an input end of the second trans-impedance amplifying unit 30221, or may be separately coupled to input ends of the first trans-impedance amplifying unit 30212 and the second trans-impedance amplifying unit 30221. For example, in FIG. 6, the output end is coupled to the input end of the first trans-impedance amplifying unit 30212.

The gain control unit 3025 may be configured to obtain a first signal physical parameter value of the reference signal and a second signal physical parameter value of the interference signal included in the amplified electrical signal. Then, the gain control unit 3025 may be further configured to: based on a difference between the first signal physical parameter value and the second signal physical parameter value, adaptively adjust an amplification multiple of the first trans-impedance amplifying unit 30212, adaptively adjust an amplification multiple of the second trans-impedance amplifying unit 30221, or adaptively adjust amplification multiples of the first trans-impedance amplifying unit 30212 and the second trans-impedance amplifying unit 30221 separately. It may be understood that, if the output end of the gain control unit 3025 is coupled to the input end of the first trans-impedance amplifying unit 30212, the gain control unit 3025 can adaptively adjust the amplification multiple of the first trans-impedance amplifying unit 30212. Other scenarios are similar to this scenario, details are not described herein again.

Optionally, the gain control unit 3025 may obtain the first signal physical parameter value or the second signal physical parameter value in at least one of the following manners: signal peak detection, signal root mean square value detection, and signal direct current level detection.
(1) It is assumed that the gain control unit 3025 obtains a first signal peak from the first differential branch circuit 3021 as the first signal physical parameter value, and obtains a second signal peak from the second differential branch circuit 3022 as the second signal physical parameter value. Through comparison, if the gain control unit 3025 determines that a difference between the first signal peak and the second signal peak is greater than or equal to a fourth difference, that is, a difference between the values of the two signals is large, a differential mode cancellation effect of the differential amplifier 3023 on an interference signal is reduced if no adjustment is performed. Therefore, the gain control unit 3025 may output a control signal based on a comparison result, where the control signal is used to adaptively adjust the amplification multiple of the first trans-impedance amplifying unit 30212 and/or the amplification multiple of the second trans-impedance amplifying unit 30221. The fourth difference may be preset or a preset value obtained based on an experimental value.

Optionally, that the gain control unit 3025 adaptively adjusts an amplification multiple of the first trans-impedance amplifying unit 30212 is used as an example. When determining that the first signal peak is greater than the second signal peak, the gain control unit 3025 decreases the amplification multiple of the first trans-impedance amplifying unit 30212. On the contrary, when determining that the first signal peak is less than the second signal peak, the gain control unit 3025 increases the amplification multiple of the first trans-impedance amplifying unit 30212. It may be understood that, if the gain control unit 3025 adaptively adjusts the amplification multiple of the second trans-impedance amplifying unit 30221, for a specific adjustment manner, refer to an implementation in which the gain control unit 3025 controls and adjusts the first trans-impedance amplifying unit 30212.

In another optional manner, if the gain control unit 3025 adaptively adjusts the amplification multiples of the first trans-impedance amplifying unit 30212 and the second trans-impedance amplifying unit 30221 separately, when determining that the first signal peak is greater than the second signal peak, the gain control unit 3025 may decrease the amplification multiple of the first trans-impedance amplifying unit 30212, and may also increase the amplification multiple of the second trans-impedance amplifying unit 30221. On the contrary, when determining that the first signal peak is less than the second signal peak, the gain control unit 3025 may increase the amplification multiple of the first trans-impedance amplifying unit 30212, and may also decrease the amplification multiple of the second trans-impedance amplifying unit 30221. In this way, when the signal physical parameter values of the two signals have a large difference, adaptive adjustment efficiency can be improved.

(2) It is assumed that the gain control unit 3025 obtains a first signal root mean square from the first differential branch circuit 3021 as the first signal physical parameter value, and obtains a second signal root mean square from the second differential branch circuit 3022 as the second signal physical parameter value. Through comparison, when the gain control unit 3025 determines that a difference between the first signal root mean square and the second signal root mean square is greater than or equal to a fifth difference, that is, a difference between the values of the two signals is large, if no adjustment is performed, a differential mode cancellation effect of the differential amplifier 3023 on an interference signal is reduced. Therefore, the gain control unit 3025 may output a control signal based on a comparison result, where the control signal is used to adaptively adjust the amplification multiple of the first trans-impedance amplifying unit 30212 and/or the amplification multiple of the second trans-impedance amplifying unit 30221. The fifth difference may be preset or a preset value obtained based on an experimental value. In addition, for a specific adjustment manner, refer to the content described in the foregoing embodiment. Details are not described herein again.

(3) It is assumed that the gain control unit 3025 obtains a first signal direct current level from the first differential branch circuit 3021 as the first signal physical parameter value, and obtains a second signal direct current level from the second differential branch circuit 3022 as the second signal physical parameter value. Through comparison, when the gain control unit 3025 determines that a difference between the first signal direct current level and the second signal direct current level is greater than or equal to a sixth difference, that is, a difference between the values of the two signals is large, if no adjustment is performed, a differential mode cancellation effect of the differential amplifier 3023 on an interference signal is reduced. Therefore, the gain control unit 3025 may output a control signal based on a comparison result, where the control signal is used to adaptively adjust the amplification multiple of the first trans-impedance amplifying unit 30212 and/or the amplification multiple of the second trans-impedance amplifying unit 30221. The sixth difference may be preset or a preset value obtained based on an experimental value. In addition, for a specific adjustment manner, refer to the content described in the foregoing embodiment. Details are not described herein again.

It should be noted that, because the second differential branch circuit 3022 includes an electrical signal, to avoid impact on a gain of the electrical signal, during implementation of this application, an implementation in which the gain control unit 3025 adaptively adjusts the amplification multiple of the first trans-impedance amplifying unit 30212 may be preferentially set.

Further, to avoid impact on a transmitted signal, during implementation of this application, the TIA 302 may further include a power-on detection unit 3026 and a power supply module 3027. An input end of the power-on detection unit 3026 may be coupled to an output end of the power supply module 3027, and an output end may be coupled to the gain control unit 3025.

The power-on detection unit 3026 may be configured to detect a power-on signal of the TIA 302. For example, a TIA power-on process is represented as a power-on pulse signal. Therefore, the power-on detection unit 3026 may detect an edge of the power-on pulse signal, to obtain the power-on signal. Optionally, if the power-on detection unit 3026 detects the power-on signal, it may be represented as the power-on signal=1; otherwise, the power-on signal=0.

In addition, the power-on detection unit 3026 may be further configured to control, within preset duration (for example, denoted by t0) starting from a time point at which the power-on signal is detected, the gain control unit 3025 to work. In this way, interference signals for the optical receiver can be canceled, and impact on a reception process of a normal optical signal can further be avoided.

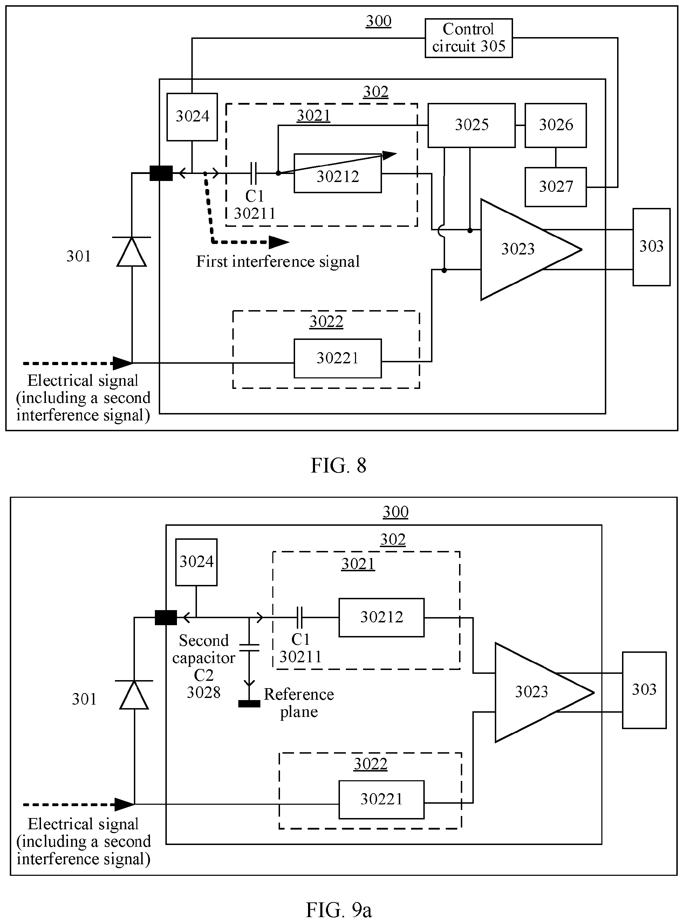

Optionally, the optical receiver may further include a control circuit 305. The control circuit 305 may be separately connected to the power supply end (for example, the first voltage regulator 3024 shown in FIG. 8) of the photodetector 301 and the power supply module 3027 of the TIA 302. The control circuit 305 may be configured to: before the photodetector 301 works or receives an optical signal, control the power supply module 3027 of the TIA 302 to be powered on. Optionally, when the first voltage regulator 3024 does not provide a bias voltage or provides a bias voltage lower than Vth for the photodetector 301, it may be considered that the photodetector 301 has not started to work, or it may be understood that no optical signal is input into the optical receiver 300. Alternatively, although the photodetector 301 can work normally when being driven by a bias voltage, the photodetector 301 has received no optical signal at this time. In this way, before an optical signal is input into the optical receiver 300, the gain control unit 3025 is controlled by using the power-on detection unit 3026 and the power supply module 3027, so that before the optical receiver 300 processes the optical signal, the gain control unit 3025 adjusts the amplification multiple of the first trans-impedance amplifying unit 30212 and/or the amplification multiple of the second trans-impedance amplifying unit 30221. Therefore, an electromagnetic crosstalk signal that may exist in the optical receiver 300 can be canceled, and impact on reception performance of the optical receiver 300 can be reduced.

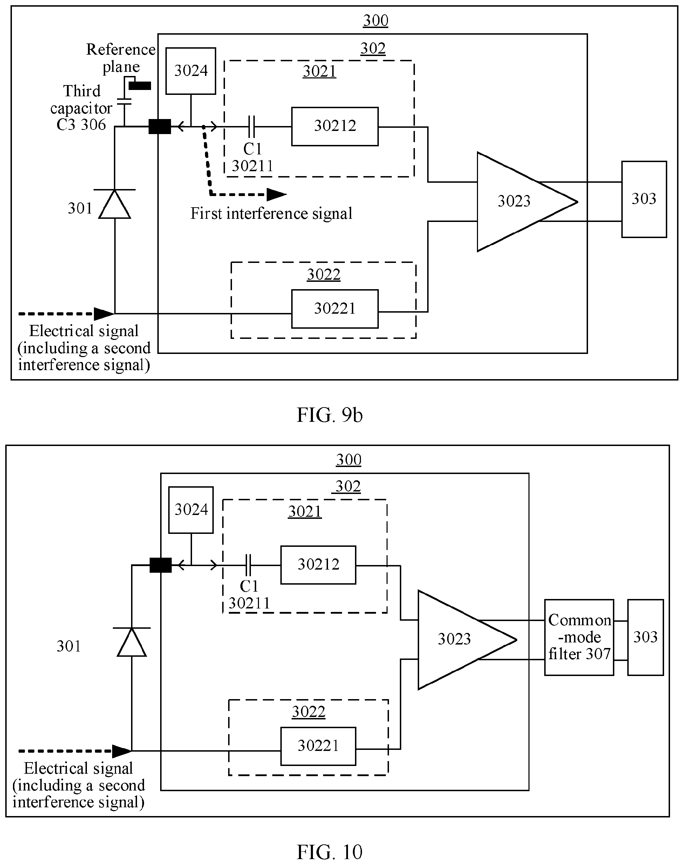

To improve electromagnetic crosstalk signal elimination efficiency of the optical receiver 300, during implementation of this application, some electromagnetic crosstalk signals may be further eliminated via a second capacitor or a third capacitor. In an optional implementation, FIG. 9a is still another diagram of an optical receiver 300 according to an embodiment of this application. For example, FIG. 9a and FIG. 9b are based on the optical receiver 300 shown in FIG. 3. It may be understood that FIG. 9a and FIG. 9b may alternatively be combined with any possible optical receiver 300 in FIG. 4 to FIG. 8. Details are not described again in this application. The TIA 302 may further include a second capacitor (C2) 3028, where an input end of the second capacitor 3028 may be coupled between the input end of the photodetector 301 and the first capacitor 30211, and an output end of the second capacitor 3028 may be coupled to a reference plane. The reference plane may be, for example, a ground cable; or a power supply end different from that of the first voltage regulator or the second voltage regulator. In this way, some electromagnetic crosstalk signals from the first voltage regulator 3024 may be eliminated via the second capacitor, so that an interference signal included in an electrical signal can be reduced, and stability of a working voltage of a photodiode can further be enhanced. A value of the second capacitor 3028 may be customized, or may be set based on an experimental value.

Optionally, the input end of the second capacitor 3028 may be coupled between the first voltage regulator 3024 and the input end of the photodetector 301, and is configured to filter out some interference signals transmitted to the second differential branch circuit 3022. In another optional manner, the input end of the second capacitor 3028 may alternatively be coupled between the first voltage regulator 3024 and the input end of the first capacitor 30211, and is configured to filter out some interference signals transmitted to the first differential branch circuit 3021. In still another optional manner, the optical receiver 300 may alternatively have two second capacitors 3028, which are respectively coupled between the first voltage regulator 3024 and the input end of the photodetector 301 and between the first voltage regulator 3024 and the input end of the first capacitor 30211.

In another optional implementation, a newly added capacitor may alternatively be disposed in the optical receiver 300, and is independent of the TIA 302. FIG. 9b is a diagram of another optical receiver 300 according to an embodiment of this application. The optical receiver 300 may further include a third capacitor (C3) 306. An input end of the third capacitor 306 may be coupled between the first voltage regulator 3024 and the photodetector 301, and an output end may also be coupled to a reference plane. It may be understood that the third capacitor 306 may alternatively be coupled between the second voltage regulator 304 and the photodetector 301. In this way, some electromagnetic crosstalk signals from the first voltage regulator 3024/the second voltage regulator 304 may be eliminated via the third capacitor 306, so that interference signals included in an electrical signal can be reduced, and stability of a working voltage of a photodiode can further be enhanced. A value of the third capacitor 306 may be customized, or may be set based on an experimental value.

In addition, according to the foregoing embodiments, a differential-mode part of an interference signal included in the optical receiver 300 can be eliminated. To prevent the common-mode part of the interference signal from affecting subsequent signal transmission, filtering out the common-mode part of the interference signal may be further considered during implementation of this application. For example, FIG. 10 is a diagram of still another optical receiver 300 according to an embodiment of this application. For example, FIG. 10 is based on the optical receiver 300 shown in FIG. 3. It may be understood that FIG. 10 may alternatively be combined with any possible optical receiver 300 in FIG. 4 to FIG. 9b. Details are not described again in this application. The optical receiver 300 may further include a common-mode filter 307. An input end of the common-mode filter 307 may be coupled to an output end of the differential amplifier. Optionally, the common-mode filter 307 may be disposed in a chip of the TIA 302, may be disposed on a transmission link between the TIA 302 and a next-stage unit 303, or may be disposed in an input stage of the next-stage unit 303. The next-stage unit 303 may be a buffer or an amplifier, for example, an LA.

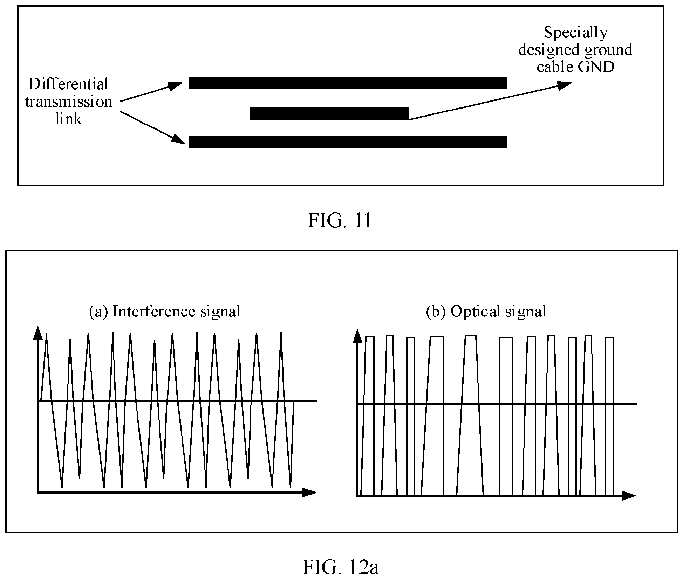

The common-mode filter 307 may be configured to filter out common-mode interference signals included in an electrical signal obtained through differential amplification processing. For example, the common-mode filter 307 may be a common-mode inductor with differential transmission line wiring that has a common-mode suppression effect via a ground cable (GND) having one end specially designed. For example, FIG. 11 is an example diagram of a common-mode filter 307 according to an embodiment of this application, and the common-mode filter 307 may be a transmission-line common-mode filter.

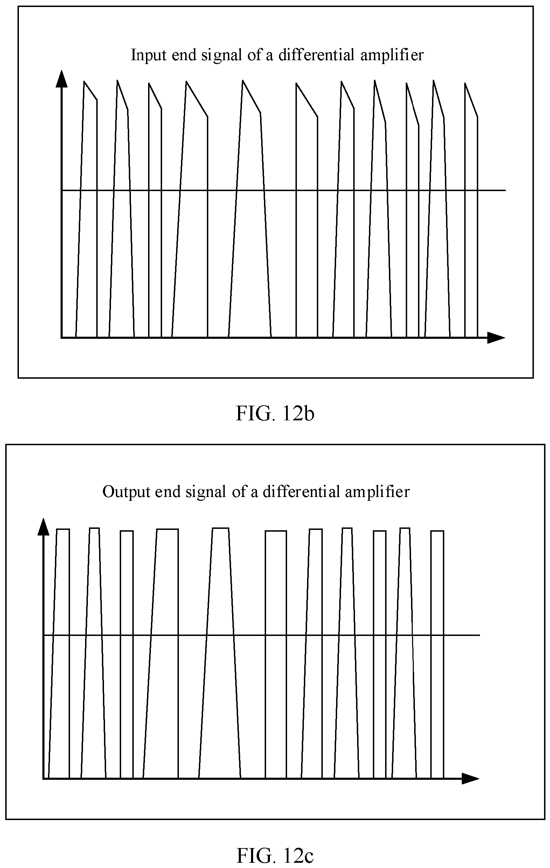

To better understand an anti-interference effect that can be achieved by the optical receiver provided in embodiments of this application, the following provides further descriptions by using example diagrams of experiment results shown in FIG. 12a to FIG. 12c. FIG. 12a is a signal diagram of an optical receiver 300 according to an embodiment of this application. It is assumed that (a) in FIG. 12a is an example diagram of an interference signal generated due to impact of a factor, for example, electromagnetic crosstalk, and (b) in FIG. 12a is an example diagram of an optical signal received by a photodetector. FIG. 12b is another signal diagram of an optical receiver 300 according to an embodiment of this application. Because an interference signal exists in a photodetector, interference exists before an electrical signal passing through the photodetector is input into a differential amplifier. As a result, a signal-to-noise ratio of the signal is reduced. FIG. 12c is still another signal diagram of an optical receiver 300 according to an embodiment of this application. According to the optical receiver provided in this embodiment of this application, two parts of input signals of a differential amplifier include interference signals whose signal physical parameter values are the same or similar. Therefore, the interference signals can be canceled at the differential amplifier, to ensure a signal-to-noise ratio of signal transmission and improve reception performance of the optical receiver.

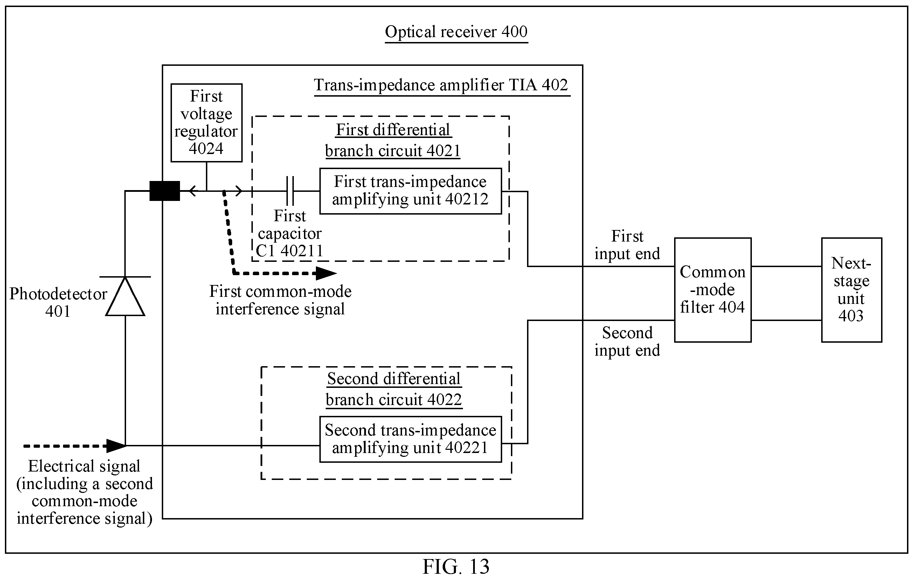

In addition, an embodiment of this application further provides another optical receiver 400. FIG. 13 is a diagram of an optical receiver 400 according to an embodiment of this application. In some possible scenarios, if the optical receiver 400 does not include a differential-mode interference signal, a common-mode filter may still be coupled in the optical receiver 400, but a differential amplifier does not need to be coupled in the optical receiver 400. For a design idea and a function of another element, refer to an implementation of the optical receiver 300 shown in FIG. 3. Details are not described herein again. For example, the optical receiver 400 may include a common-mode filter 404, and an input end of the common-mode filter 404 may be separately coupled to an output end of a first differential branch circuit 4021 and an output end of a second differential branch circuit 4022, an output end of the common-mode filter 404 may be coupled to a next-stage unit 403 included in the optical receiver 400. The next-stage unit 403 may be a buffer or an amplifier, for example, an LA. Optionally, the common-mode filter 404 may be disposed in a chip of a TIA 402, may be disposed on a transmission link between the TIA 402 and the next-stage unit 403, or may be disposed in an input stage of the next-stage unit 403.

The common-mode filter 404 may be configured to filter out a first common-mode interference signal included in the first differential branch circuit 4021 and a second common-mode interference signal included in an amplified electrical signal.

It should be noted that the optical receiver 400 shown in FIG. 13 may be combined with any embodiment of FIG. 4 to FIG. 9b described above, and details are not described herein again.

An embodiment of this application further provides an optical communication device, including the optical receiver described in the foregoing embodiments and one or more processors. The one or more processors are configured to receive and process a data packet transmitted by the optical receiver. The optical communication device may be an ONT, an OLT, or an optical transmission and optical processing device in another optical communication system.

It should be noted that in descriptions of this application, "at least one" means one or more, and "a plurality of means two or more. In view of this, in embodiments of this application, "a plurality of may alternatively be understood as "at least two". The term "and/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects. In addition, it should be understood that in descriptions of this application, terms such as "first" and "second" are merely used for distinguishing and description, but should not be understood as indicating or implying relative importance, or should not be understood as indicating or implying a sequence.

It should be noted that, "coupling" in embodiments of this application may be understood as an electrical connection, and coupling between two elements may be direct or indirect coupling between the two elements. For example, that A is connected to B may mean that A is directly coupled to B, or mean that A is indirectly coupled to B through one or more other elements. For example, that A is coupled to B may mean that A is directly coupled to C, C is directly coupled to B, and A is coupled to B through C. In some scenarios, "coupling" may also be understood as connection.

In various embodiments of this application, unless otherwise specifically stated or there is a logic conflict, terms and/or descriptions in different embodiments are consistent and may be mutually referenced, and technical features in different embodiments may be combined based on an internal logical relationship thereof, to form a new embodiment.

In this application, the word "example" is used to represent giving an example, an illustration, or a description. Any embodiment or design solution described as an "example" in this application should not be explained as being more preferred or having more advantages than another embodiment or design solution. Alternatively, it may be understood as that the word "example" is used to present a concept in a specific manner, and does not constitute a limitation on this application.

It may be understood that, in this application, various numeric numbers are distinguished merely for ease of description and are not used to limit the scope of embodiments of this application. The serial numbers of the foregoing processes do not mean execution sequences. The execution sequences of the processes need to be determined based on functions and internal logic of the processes. In addition, the terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device.

Although this application is described with reference to specific features and embodiments thereof, it is clear that various modifications and combinations may be made to them without departing from the spirit and scope of this application. Correspondingly, this specification and the accompanying drawings are merely example descriptions of solutions defined by the appended claims, and are considered as any or all of modifications, variations, combinations, or equivalents that cover the scope of this application.

Clearly, a person skilled in the art can make various modifications and variations to this application without departing from the spirit and scope of the present invention. This application is intended to cover the modifications and variations of embodiments of this application provided that they fall within the scope of protection defined by the following claims and their equivalent technologies.

## Claims

1. An optical receiver, comprising a photodetector and a trans-impedance amplifier, wherein the trans-impedance amplifier comprises a first differential branch circuit, a second differential branch circuit, and a differential amplifier, wherein
the first differential branch circuit comprises a first capacitor and a first trans-impedance amplifying unit, wherein an input end of the first capacitor receives an input signal from a power supply end of the photodetector, an output end of the first capacitor is coupled to an input end of the first trans-impedance amplifying unit, and an output end of the first trans-impedance amplifying unit is coupled to a first input end of the differential amplifier; and
the second differential branch circuit comprises a second trans-impedance amplifying unit, an input end of the second trans-impedance amplifying unit is coupled to an output end of the photodetector, and an output end of the second trans-impedance amplifying unit is coupled to a second input end of the differential amplifier, wherein
the first differential branch circuit is configured to: amplify the input signal and output a reference signal;
the second differential branch circuit is configured to amplify an electrical signal output by the photodetector, wherein signal physical parameter values of the reference signal and an interference signal comprised in an amplified electrical signal are the same; or a signal physical parameter value difference between the reference signal and an interference signal comprised in an amplified electrical signal is less than a first difference; and
the differential amplifier is configured to perform differential amplification processing on the reference signal and the amplified electrical signal.

2. The optical receiver according to claim 1, wherein the trans-impedance amplifier further comprises a first voltage regulator, wherein an output end of the first voltage regulator is coupled between an input end of the photodetector and the first capacitor; or
the optical receiver further comprises a second voltage regulator, wherein an output end of the second voltage regulator is coupled to an input end of the photodetector, wherein
the first voltage regulator or the second voltage regulator is configured to provide a bias voltage for the photodetector.

3. The optical receiver according to claim 2, wherein the trans-impedance amplifier further comprises a second capacitor, wherein an input end of the second capacitor is coupled between the input end of the photodetector and the first capacitor, and an output end of the second capacitor is coupled to a reference plane; or
the optical receiver further comprises a third capacitor, wherein an input end of the third capacitor is coupled between the first voltage regulator and the photodetector, or coupled between the second voltage regulator and the photodetector, and an output end of the third capacitor is coupled to a reference plane, wherein
the second capacitor or the third capacitor is configured to filter out some interference from the first voltage regulator or the second voltage regulator, wherein a capacitance value of the second capacitor or the third capacitor is greater than a preset capacitance threshold.

4. The optical receiver according to any one of claims 1 to 3, further comprising a common-mode filter, wherein an input end of the common-mode filter is coupled to an output end of the differential amplifier, wherein
the common-mode filter is configured to filter out common-mode interference signals comprised in an electrical signal obtained through differential amplification processing.

5. The optical receiver according to claim 4, wherein the common-mode filter is disposed in a chip of the trans-impedance amplifier, disposed on a transmission link between the trans-impedance amplifier and a next-stage unit, or disposed in an input stage of the next-stage unit, wherein the next-stage unit is a buffer or an amplifier.

6. The optical receiver according to any one of claims 1 to 5, wherein that signal physical parameter values of the reference signal and an interference signal comprised in an amplified electrical signal are the same; or a signal physical parameter value difference between the reference signal and an interference signal comprised in an amplified electrical signal is less than a first difference comprises:
values of the first capacitor and parasitic capacitance of the photodetector are the same; or a difference between values of the first capacitor and parasitic capacitance of the photodetector is less than a second difference; and
amplification multiples of the first trans-impedance amplifying unit and the second trans-impedance amplifying unit are equal; or a difference between amplification multiples of the first trans-impedance amplifying unit and the second trans-impedance amplifying unit is less than a third difference.

7. The optical receiver according to any one of claims 1 to 5, wherein that signal physical parameter values of the reference signal and an interference signal comprised in an amplified electrical signal are the same; or a signal physical parameter value difference between the reference signal and an interference signal comprised in an amplified electrical signal is less than a first difference comprises one or a combination of the following manners:
adjusting an amplification multiple of the first trans-impedance amplifying unit; and
adjusting an amplification multiple of the second trans-impedance amplifying unit.

8. The optical receiver according to claim 7, wherein the trans-impedance amplifier further comprises a gain control unit, wherein
an input end of the gain control unit is coupled to an input end or the output end of the differential amplifier; and the output end is coupled to the input end of the first trans-impedance amplifying unit, coupled to the input end of the second trans-impedance amplifying unit, or separately coupled to the input end of the first trans-impedance amplifying unit and the input end of the second trans-impedance amplifying unit, wherein
the gain control unit is configured to obtain a first signal physical parameter value of the reference signal and a second signal physical parameter value of the interference signal comprised in the amplified electrical signal; and
the gain control unit is further configured to: based on a difference between the first signal physical parameter value and the second signal physical parameter value, adjust the amplification multiple of the first trans-impedance amplifying unit, adjust the amplification multiple of the second trans-impedance amplifying unit, or separately adjust the amplification multiple of the first trans-impedance amplifying unit and the amplification multiple of the second trans-impedance amplifying unit.

9. The optical receiver according to claim 8, wherein that the gain control unit is specifically configured to:
increase or decrease the amplification multiple of the first trans-impedance amplifying unit, to allow the difference between the first signal physical parameter value and the second signal physical parameter value be less than a fourth difference;
increase or decrease the amplification multiple of the second trans-impedance amplifying unit, to allow the difference between the first signal physical parameter value and the second signal physical parameter value be less than a fifth difference; or
increase or decrease the respective amplification multiples of the first trans-impedance amplifying unit and the second trans-impedance amplifying unit, to allow the difference between the first signal physical parameter value and the second signal physical parameter value be less than a sixth difference.

10. The optical receiver according to any one of claims 1 to 9, wherein the first signal physical parameter value or the second signal physical parameter value is obtained in at least one of the following manners: signal peak detection, signal root mean square value detection, and signal direct current level detection.

11. The optical receiver according to claim 8 or 9, wherein the trans-impedance amplifier further comprises a power-on detection unit and a power supply module, wherein
an input end of the power-on detection unit is coupled to an output end of the power supply module, and an output end is coupled to the gain control unit;
the power-on detection unit is configured to detect a power-on signal of the trans-impedance amplifier; and
the power-on detection unit is further configured to control, within preset duration starting from a time point at which the power-on signal is detected, the gain control unit to work.

12. The optical receiver according to claim 11, wherein the optical receiver further comprises a control circuit, and the control circuit is separately connected to the photodetector and the power supply module of the trans-impedance amplifier, wherein
the control circuit is configured to: before the photodetector works or receives an optical signal, control the power supply module of the trans-impedance amplifier to be powered on.

13. An optical receiver, comprising a photodetector and a trans-impedance amplifier, wherein the trans-impedance amplifier comprises a first differential branch circuit, a second differential branch circuit, and a common-mode filter, wherein
the first differential branch circuit comprises a first capacitor and a first trans-impedance amplifying unit, wherein an input end of the first capacitor receives an input signal from a power supply end of the photodetector, an output end of the first capacitor is coupled to an input end of the first trans-impedance amplifying unit, and an output end of the first trans-impedance amplifying unit is coupled to a first input end of the common-mode filter; and
the second differential branch circuit comprises a second trans-impedance amplifying unit, an input end of the second trans-impedance amplifying unit is coupled to an output end of the photodetector, and an output end of the second trans-impedance amplifying unit is coupled to a second input end of the common-mode filter, wherein
the first differential branch circuit is configured to: amplify the input signal and output a reference signal;
the second differential branch circuit is configured to amplify an electrical signal output by the photodetector, wherein signal physical parameter values of the reference signal and an interference signal comprised in an amplified electrical signal are the same; or a signal physical parameter value difference between the reference signal and an interference signal comprised in an amplified electrical signal is less than a first difference; and
the common-mode filter is configured to perform filtering processing on the reference signal and the amplified electrical signal.

14. The optical receiver according to claim 13, wherein the common-mode filter is disposed in a chip of the trans-impedance amplifier, disposed on a transmission link between the trans-impedance amplifier and a next-stage unit, or disposed in an input stage of the next-stage unit, wherein the next-stage unit is a buffer or an amplifier.

15. An optical communication device, comprising the optical receiver according to any one of claims 1 to 12 or the optical receiver according to claim 13 or 14, and one or more processors, wherein
the one or more processors are configured to receive and process a data packet transmitted by the optical receiver.
